# EUROPÄISCHE PATENTSCHRIFT

(11) **EP 1 495 493 B1**
(45) Veröffentlichungstag und Bekanntmachung des Hinweises auf die Patenterteilung: **03.06.2015**
(21) Anmeldenummer: 03746297.5
(22) Anmeldetag: 15.04.2003
(51) Int. Cl.: H01L 23/58

(54) **Verwendung einer Borosilikatglasschicht**
Use of a borosilicateglass layer
Utilisation d'une couche de verre de borosilicate

(30) Priorität: 15.04.2002 DE 20205830 U; 23.05.2002 DE 10222958; 23.05.2002 DE 10222964; 23.05.2002 DE 10222609; 13.11.2002 DE 10252787; 16.01.2003 DE 10301559
(43) Veröffentlichungstag der Anmeldung: 12.01.2005
(73) Patentinhaber: Schott AG, 55122 Mainz (DE)
(72) Erfinder: MUND, Dietrich, 84101 Obersüssbach (DE); LEIB, Jürgen, 85354 Freising (DE)
(74) Vertreter: Blumbach Zinngrebe
(86) Internationale Anmeldenummer: PCT/EP2003/003881
(87) Internationale Veröffentlichungsnummer: WO 2003/088354

(56) Entgegenhaltungen:
- EP-A- 1 139 424
- EP-A- 1 178 529
- CH-A- 387 175
- US-A- 4 374 391
- US-A- 4 492 717
- US-A- 4 870 034
- US-A- 5 436 084
- US-A- 5 547 904
- US-A- 5 780 163
- US-B1- 6 268 058

## Beschreibung

Die Erfindung betrifft die Verwendung einer Borosilikatglass umfassenden Beschichtung als Schutzgegen das Freilegen der Schaltung eines elektronischen Bauteils durch Wegätzen der Beschichtung.

Die Komplexität von elektronischen Schaltungen, insbesondere integrierten Schaltungen wird aufgrund der anhaltenden technischen Weiterentwicklung immer komplizierter. Dies ruft Produktpiraten auf den Plan, welche eine integrierte Schaltung aus dem Gehäuse freilegen, um diese zu analysieren und die Ergebnisse gegen den Willen des Herstellers zu missbrauchen sowie insbesondere die integrierte Schaltung zu kopieren.

Dieses Problem ist besonders relevant bei elektronischen Schaltungen, für die ein erhöhtes Geheimhaltungsinteresse seitens des Herstellers besteht, wie z.B. bei Schaltkreisen zur Entschlüsselung von verschlüsselten Signalen, insbesondere für das Bezahlfernsehen (Pay-TV) und Plastik Chipkarten.

Zwar werden Chips typischerweise in Gehäusen oder ähnlich gekapselt, doch lassen sich diese mit entsprechenden Mitteln wieder entfernen und bieten daher keinen hinreichenden Schutz vor Missbrauch oder Kopie.

Daher ist es eine Aufgabe der vorliegenden Erfindung, die Verwendung, einer Beschichtung mit dem Ziel eines wirksamen und sicheren Kopierschutzes für eine elektronische Schaltung zu ermöglichen.

Die EP 1 178 529 A2 beschreibt eine Halbleitervorrichtung, bei welcher eine Schutzschicht auf einen Schaltkreis laminiert ist. Auf der Schutzschicht befindet sich eine leitende lichtblockende Schicht, welche mit einem Widerstandsmesskreis verbunden und von einer korrosionsschützenden Aluminiumoxidschicht abgedeckt ist. Wird die lichtblockende Schicht, etwa auf chemischem Wege entfernt, kommt es durch den erhöhten Widerstand zu einem Ansprechen des Widerstandsmesskreises und einer Fehlfunktion oder Zerstörung des Schaltkreises.

Die US 4,374,391 A beschreibt weiterhin eine Schutzschicht für Halbleitervorrichtungen, welche durch Sputtern eines Targets aus B₂O₃ und SiO₂ hergestellt wird.

Die CH 387 175 beschreibt das Überziehen elektrischer Schaltelemente mit einem Glas der Zusammensetzung Arsen/Thallium/Selen oder Arsen/Thallium/Schwefel, welches gut unter anderem auf einem Borsilikatglas haften soll. Aus der US 6,268,058 B1 ist eine Speicherkarte bekannt, auf welcher eine Borosilikatglasscheibe auflaminiert ist.

Die US 5,436,084 A beschreibt das Beschichten eines elektronischen Substrats mit einer Borosilazan-Schicht mit Füllstoffen. Diese Schicht wird anschließend durch Pyrolyse in eine keramische Schicht umgewandelt.

Aus der US 5,780,163 A ist ein Verfahren zur Herstellung einer Kopierschutzschicht zum Schutz von elektronischen oder mikroelektronischen Vorrichtungen bekannt, bei welchem eine erste siliziumoxid-haltige Keramikschicht zur Planarisierung der Oberfläche aufgebracht wird. Als hermetische Barriere wird darauf eine Siliziumcarbidschicht abgeschieden. Eine dritte Lage wird durch eine poröse siliziumoxid-haltige Keramikschicht gebildet, die mit einem undurchsichtigen Material imprägniert wird. Darauf wird als vierte Lage eine Metallschicht abgeschieden, die wiederum von einer fünften Lage in Form einer poröse siliziumoxid-haltige Keramikschicht abgedeckt wird.

Die Aufgabe der Erfindung wird in überraschend einfacher Weise bereits durch den Gegenstand der Ansprüche 1 und 12 gelöst. Weitere Ausgestaltungen der Erfindung sind Gegenstand der Unteransprüche.

Für die erfindungsgemäße Verwendung eines Verfahrens wird ein Substrat bereitgestellt, welches Halbleiterstrukturen auf einer ersten Seite des Substrats aufweist. Dieses Substrat ist z.B. ein noch nicht in Chips unterteilter Silizium-Wafer mit aufgedruckten Schaltkreisen.

Die elektronische Schaltung umfasst vorzugsweise einen Schaltkreis, eine integrierte Schaltung und/oder einen Sensor.

Weiter werden Materialien zur Beschichtung des Substrats bereitgestellt und auf das Substrat zur Beschichtung aufgedampft. Die Beschichtung erfüllt insbesondere die Funktion eines Schutzes vor dem Ausspähen, Missbrauchen und Kopieren einzelner Halbleiterstrukturen und/oder der gesamten Schaltung. Sie schützt insbesondere Schaltungen mit Halbleiterstrukturen, welche elektronische Entschlüsselungsmittel umfassen, da diese besonders geheimhaltungsbedürftig sind. Ein wichtiger Anwendungsbereich der Erfindung ist daher der Schutz vor Produktpiraterie und die Entschlüsselung durch unberechtigte Personen von Decodern für den Bezahlrundfunk, insbesondere für das Bezahlfernsehen (Pay-TV) oder bei sicherheitsrelevanten Schaltkreisen auf Chipkarten.

Eine Beschichtung vorzusehen hat den Vorteil, dass sie einerseits einen sehr wirksamen Kopierschutz, bzw. Analyse- oder Ausspähschutz bedeutet und anderseits einfach auf das Substrat oder den Wafer aufgebracht werden kann.

Darüber hinaus bietet eine Beschichtung einen gleichmäßigen Schutz über den gesamten beschichteten Bereich, was sogar das Ausspähen von Teilen der Schaltung wirksam verhindern kann.

Insbesondere kann eine Beschichtung auch als Teilschritt im Herstellungsverfahren der Schaltung integriert sein. Dieser Vorteil wirkt sich besonders positiv aus, wenn ohnehin Beschichtungen, z.B. Passivierungs- oder Stabilisierungschichten, aufgetragen werden sollen. In diesem Fall können die Beschichtung und eine oder mehrere weitere Beschichtungen, z.B. eine Passivierungs- oder Stabilisierungsbeschichtung in derselben Vorrichtung, insbesondere Vakuumkammer durchgeführt werden, vorzugsweise ohne, dass das Substrat zwischen den Beschichtungen aus der Vorrichtung entfernt wird, und so ein kosten- und zeitintensiver Umrüstvorgang vermieden werden kann.

Besonders vorteilhaft hinsichtlich der Verfahrensökonomie bei der Herstellung von Halbleiterprodukten ist, dass die Beschichtung flächig auf den noch unzerteilten Wafer aufgetragen werden kann, so dass eine Vielzahl von Chips in einem Arbeitsschritt mit der Beschichtung versehen werden können. Dies ist insbesondere bei Chips, welche auf Wafer-Ebene gehäust werden, dem sogenannten Wafer-Level Packaging (WLP), von Vorteil. Hierbei kann die erfindungsgemäße Verwendung das WLP einerseits ergänzen, andererseits aber sogar zumindest Teilschritte des WLP ersetzen, nämlich insbesondere wenn die Beschichtung derart ausgebildet ist, dass sie gleichzeitig eine Gehäuse- und/oder eine Stabilisierungsfunktion erfüllt, d.h. ein integraler Bestandteil des Gehäuses ist.

Es ist beabsichtigt, dass ein Ätzverfahren, welches die Beschichtung auflöst, ebenfalls das Substrat derart angreift, dass die Halbleiterstrukturen zumindest teilweise angelöst, aufgelöst, angegriffen und/oder zerstört werden und/oder die logische Schaltung nach Entfernen der Beschichtung nicht mehr nachempfunden werden kann, so dass ein Ausspäh- oder ein Kopierversuch bei welchem die Beschichtung abgeätzt werden soll, zum Scheitern verurteilt ist. Als mögliche Ätzverfahren kommen insbesondere chemisches oder Nassätzen, sowie Trocken- oder Plasmaätzen in Betracht.

Vorteilhafterweise ist eine selektive Ablösung der Beschichtung, ohne die auf dem Substrat oder Wafer vorhandenen Halbleiterstrukturen zu schädigen, somit unmöglich oder zumindest erheblich erschwert. Die Strukturen können daher nicht ohne weiteres unberechtigterweise kopiert werden.

Eine Silizium enthaltende Beschichtung ist hinsichtlich des Ätzverhaltens sehr gut an Substrate mit Halbleiterschichten auf Siliziumbasis angepasst.

Die Beschichtung wird als eine zumindest bereichsweise geschlossene Schicht aufgebracht und ist insbesondere fest, vollständig und/oder flächig mit dem Substrat verbunden und/oder haftet auf diesem, so dass auch andere als ätzende Angriffe abgewehrt werden. Es sind zumindest die Bereiche des Substrats in welchen sich die Halbleiterstrukturen befinden vollständig von der Beschichtung bedeckt und vorzugsweise hermetisch verkapselt.

Die Erfinder haben überraschenderweise festgestellt, dass sich Glas als Material für die Beschichtung eignet. Daher wird eine Glasschicht auf das Substrat aufgedampft. Dabei wird ein Borosilikatglas mit Anteilen von Aluminiumoxid und Alkalioxid verwendet. Als besonders geeignet erwies sich in Versuchen das Aufdampfglas 8329 der Fa. Schott.

Das Glas wird aufgedampft. Das Aufdampfen verursacht vorteilhafterweise eine sehr feste Bindung mit dem Substrat, ohne dass z.B. Klebstoffe notwendig sind.

Diesbezüglich wird auch auf die Anmeldungen
DE 202 05 830.1, eingereicht am 15.04.2002,
DE 102 22 964.3, eingereicht am 23.05.2002;
DE 102 22 609.1, eingereicht am 23.05.2002;
DE 102 22 958.9, eingereicht am 23,05,2002;
DE 102 52 787.3, eingereicht am 13.11.2002;
DE 103 01 559.0, eingereicht am 16.01.2003
desselben Anmelders verwiesen.

Folgende Prozeßparameter für das Aufbringen einer geschlossenen Glasschicht sind vorteilhaft:
Oberflächenrauhigkeit des Substrats: < 50µm
BIAS-Temperatur während der Verdampfung: ≈100°C
Druck während der Verdampfung: 10⁻⁴ mbar

Vorteilhaft wird das Aufdampfen mittels Plasma-Ionen-unterstütztem Aufdampfen (PIAD) durchgeführt. Dabei wird zusätzlich ein Ionenstrahl auf das zu beschichtende Substrat gerichtet. Der Ionenstrahl kann mittels einer Plasmaquelle, beispielsweise durch Ionisation eines geeigneten Gases erzeugt werden. Durch das Plasma erfolgt eine zusätzliche Verdichtung der Schicht sowie die Ablösung lose haftender Partikel auf der Substratoberfläche. Dies führt zu besonders dichten und defektarmen abgeschiedenen Schichten.

Die Beschichtung ist entweder durchsichtig, was für optoelektronische Bauelemente vorteilhaft ist oder undurchsichtig, intransparent, getönt, gefärbt, trübe, mattiert oder ähnlich sichtbehindernd.

Silizium als Hauptkomponente von Wafer und Schutzschicht kann im wesentlichen nur durch die gleichen Ätzchemikalien entfernt werden, was die Möglichkeit der selektiven Abätzung nahezu ausschließt. Sogar bei Anwendung von Trockenätzverfahren ist eine Materialkombination von Silizium-Substrat bzw. -Wafer und Silizum-Glas gegenüber selektiver Ätzung geschützt, da die Information über den Ätzstop nur anhand der Elemente der Halbleiterschicht oder der Glasschicht gewonnen werden kann. Erst nach Erhalt dieser Information, also nach Schädigung der Halbleiterschichten, kann der Ätzprozess gestoppt werden.

Vorzugsweise beträgt die Oberflächenrauhigkeit des Substrats höchstens 50 µm, 10 µm oder 5 µm und/oder der Wärmeausdehnungskoeffizient des Substrats und des Aufdampfglases stimmen überein.

Als besonders effektive Aufdampfverfahren haben sich thermische Bedampfung und Elektronenstrahlbedampfung erwiesen. Es werden vorteilhaft hohe Aufdampfraten von mindestens 0,01 µm/min, 0,1 µm/min, 1 µm/min, 2 µm/min und/oder bis zu 10 µm/min, 8 µm/min, 6 µm/min oder 4 µm/min erzielt. Das übertrifft bekannte Sputterraten um ein Vielfaches. Dadurch lassen sich schnell und effektiv Schichtdicken mit einer Dicke von 0,01 µm bis 1000 µm, vorzugsweise 10 µm bis 100 µm auf das Substrat auftragen. Bisher aufgebrachte Sputterschichten von Einkomponentensystemen (typischerweise SiO₂) besitzen Sputterraten von lediglich wenigen Nanometern pro Minute.

Vorzugsweise wird das Beschichten des Substrats bei einer Bias-Temperatur von unter 300° C, insbesondere unter 150° C und besonders bevorzugt im Bereich von 100 ° C durchgeführt. Zum Aufdampfen der Glasschicht hat sich eine Hintergrunddruck von 10⁻³ mbar bis 10⁻⁷ mbar, insbesondere im Bereich von 10⁻⁵ mbar bewährt.

Gemäß einer bevorzugten Weiterbildung der Erfindung wird zumindest eine weitere Schicht, z.B. eine Glas- , Keramik-, Metall oder Kunststoffschicht, insbesondere als optische und röntgenoptische Schutzschicht und/oder als Schutzschicht gegen kapazitives und induktives Ausspähen aufgebracht, wobei diese Schutzschicht für elektromagnetische Wellen, insbesondere für Röntgenstrahlen im wesentlichen undurchlässig ist, bzw. eine kapazitive und/oder induktive Abschirmung umfasst. Diese Schicht kann sowohl ganzflächig, günstigstenfalls partiell die schützenden Bereiche des Substrates überdecken. Dabei kann die Schutzschicht aber auch derart aufgebracht sein, dass dennoch Signale kontaktlos, insbesondere induktiv oder kapazitiv ein- oder ausgekoppelt werden können.

Gemäß einer bevorzugten Ausführungsform werden zumindest ein Teil der für die Funktion der Schaltkreise notwendigen Leiterbahnen und/oder passiven Bauelemente in die Schutzschichtenfolge mit eingebaut, so dass bei Entfernung der Schutzschichten die Logik der Schaltkreise nicht mehr oder nur unter erschwerten Bedingungen nachvollziehbar ist. Gemäß einer bevorzugten Weiterbildung der Erfindung wird zumindest eine weitere Schicht, z.B. eine Glas- oder Kunststoffschicht, insbesondere als Passivierungsschicht und/oder als mechanische Verstärkung auf einer der ersten Seite gegenüberliegenden zweiten Seite des Substrats aufgebracht. Eine Kombination aus einer Glasschicht mit Passivierungsfunktion und einer darauf aufgebrachten mechanisch verstärkenden Kunststoffschicht ist von besonderem Vorteil.

Die vorliegende Erfindung steht in Zusammenhang mit den Erfindungen der deutschen Patentanmeldungen DE-102 22 964.3-33, angemeldet am 23.05.02 und DE-102 22 609.1-33, angemeldet am 23.05.02 sowie der deutschen Gebrauchsmusteranmeldung 202 05 830.1, angemeldet am 15.04.02.

Im folgenden wird die Erfindung anhand bevorzugter Ausführungsbeispiele und unter Bezugnahme auf die Figuren näher erläutert.

### Kurzbeschreibung der Figuren

Es zeigen
- Fig. 1a: einen Querschnitt durch einen Abschnitt eines Wafers mit einer aufgedampften Glasschicht auf der Oberseite,
- Fig. 1b: wie Fig. 1a mit einer weiteren aufgedampften Glasschicht auf der Unterseite,
- Fig. 1c: wie Fig. 1a mit einer weiteren geschlossenen Schutzschicht aus Metall, Keramik, Glas oder Kunststoff sowie einer abschließenden aufgedampften Glasschicht auf der Oberseite
- Fig. 1d: wie Fig. 1a mit einer weiteren nicht geschlossenen Schutzschicht aus Metall, Keramik, Glas oder Kunststoff sowie einer abschließenden aufgedampften Glasschicht auf der Oberseite
- Fig. 1e: wie Fig. 1a mit einer weiteren nicht geschlossenen Schutzschicht (Leiterbahnen, passive Bauelemente) aus Metall oder Keramik sowie einer abschließenden aufgedampften Glasschicht auf der Oberseite
- Fig. 2: einen Waferabschnitt mit Glas und Kunststoffschicht,
- Fig. 3: eine Herstellung von Anschlüssen an den Wafer,
- Fig. 4: wie Fig. 3 mit einer Kunststoff-Passivierung der Waferunterseite,
- Fig. 5: eine Beschichtung der Waferunterseite mit Aufdampfglas,
- Fig. 6: ein Anbringen eines Ball Grid Arrays an den Wafer aus Fig. 5,
- Fig. 7a: eine weitere Anbringungsart des Ball Grid Arrays an den Wafer,
- Fig. 7b: wie Fig. 7a mit einer Kunststoffschicht auf der Unterseite des Wafers,
- Fig. 8: eine Kapselung der Unterseite eines Wafers,
- Fig. 8a: eine weitere Kapselung der Unterseite eines Wafers,
- Fig. 9: ein Anbringen von Ball Grid Arrays am Wafer aus Fig. 8 oder Fig. 8a,
- Fig. 10: ein Schema einer Verdampfungsanordnung,
- Fig. 11: einen Querschnitt durch einen Waferabschnitt mit einer Kunststoffschicht und einer geschlossenen Glasschicht auf der Oberseite,
- Fig. 11a: einen Querschnitt durch einen Waferabschnitt mit einer Kunststoffschicht und einer strukturierten Glasschicht auf der Oberseite
- Fig. 12: den Waferabschnitt aus Fig. 11 nach Abschleifen der Glasschicht und/oder Entfernen der Kunststoffschicht mittels Lift Off Technik,
- Fig. 13: den Waferabschnitt aus Fig. 12 nach Aufbringen eines Ball Grid Arrays,
- Fig. 14: Ergebnisse einer TOF-SIMS-Messung und
- Fig. 15: eine schematische Darstellung eines Wafers mit Lochmaske für einen Dichtigkeitstest.

### Detaillierte Beschreibung der Erfindung

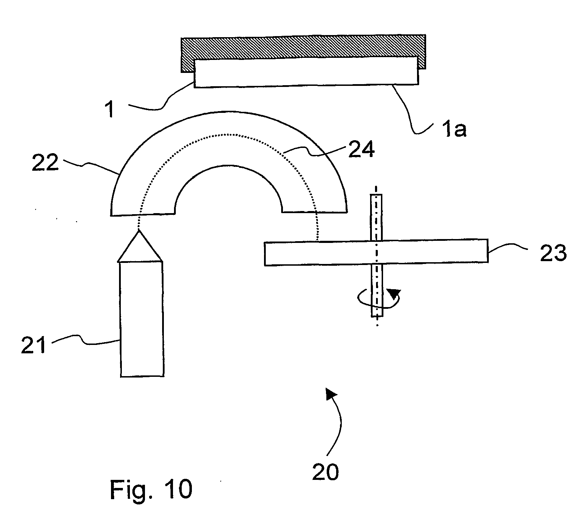

Fig. 10 zeigt die Anordnung eines Substrats 1 zu einer Aufdampfglasquelle 20. Diese besteht aus einem Elektronenstrahlerzeuger 21, einer Strahlumlenkeinrichtung 22 und einem Glastarget 23, das von einem Elektronenstrahl 24 getroffen wird. An der Auftreffstelle des Elektronenstrahls verdampft das Glas und schlägt sich an der ersten Seite 1a des Substrats 1 nieder. Um das Glas des Targets 23 möglichst gleichmäßig verdampfen zu lassen, wird das Target gedreht und der Strahl 24 gewobbelt.

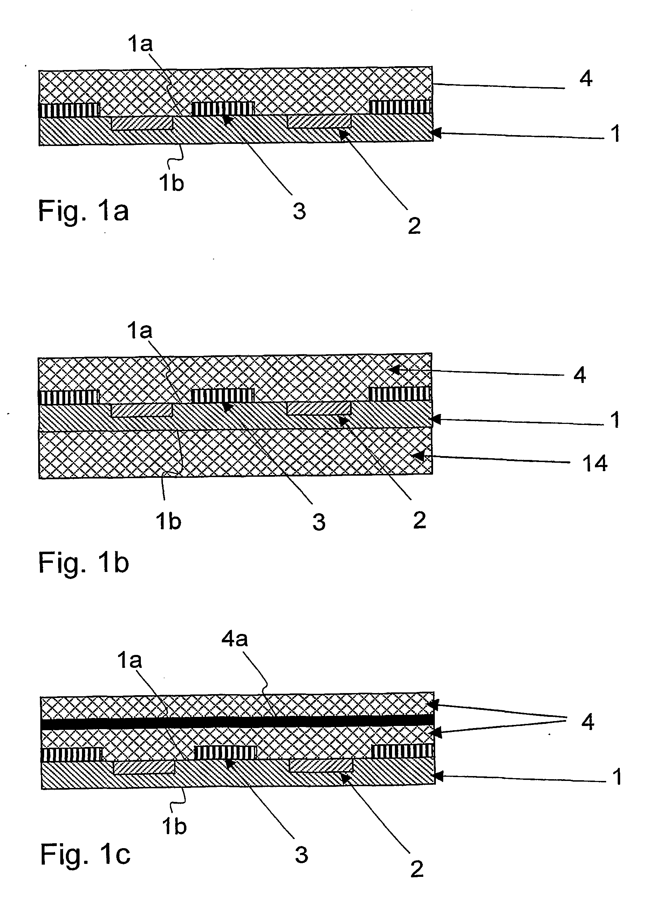

Wegen näherer Einzelheiten des möglichen Substrats 1 wird Bezug auf Fig. 1a und 1b genommen. Ein Siliziumwafer als das Substrat 1 weist Bereiche 2 mit Halbleiterstrukturen sowie Bereiche 3 mit Anschlußstrukturen auf, die hier als Bond Pad, beispielsweise aus Aluminium, ausgebildet sind. Der Siliziumwafer stellt ein Substrat mit einer Oberflächenrauhigkeit < 5µm dar. Die Oberseite 1a des Substrats liegt der Unterseite 1b gegenüber. Auf die Oberseite 1a ist eine Glasschicht 4 niedergeschlagen worden, die vorzugsweise aus dem Aufdampfglas des Typs 8329 der Firma Schott gewonnen wurde. Dieser Glastyp kann durch Einwirkung des Elektronenstrahls 24 weitgehend verdampft werden, wobei man in evakuierter Umgebung mit 10⁻⁴ mbar Restdruck und einer BIAS Temperatur während der Verdampfung von 100°C arbeitet. Unter diesen Bedingungen wird eine dichte geschlossene Glasschicht 4 erzeugt, die weitgehend gegenüber Gasen und Flüssigkeiten, auch Wasser, dicht ist, jedoch Licht durchlässt, was im Falle von elektrooptischen Bauteilen wichtig ist.

Die Unterseite 1b des Wafers steht für weitere Bearbeitungsschritte zur Verfügung, welche das Nass-, Trocken- und Plasmaätzen bzw. -reinigen umfassen.

Fig. 1b zeigt das Substrat 1 wie in Fig. 1a, allerdings mit einer zusätzlichen Glasschicht 14, welche auf die Unterseite 1b aufgedampft ist.

Fig. 1c zeigt das Substrat 1 wie in Fig. 1a, allerdings mit einer zusätzlichen geschlossenen Schutzschicht 4a, umfassend oder bestehend aus Metall, Keramik, Glas oder Kunststoff sowie einer weiteren abschließenden aufgedampften Glasschicht 4 auf der Oberseite.

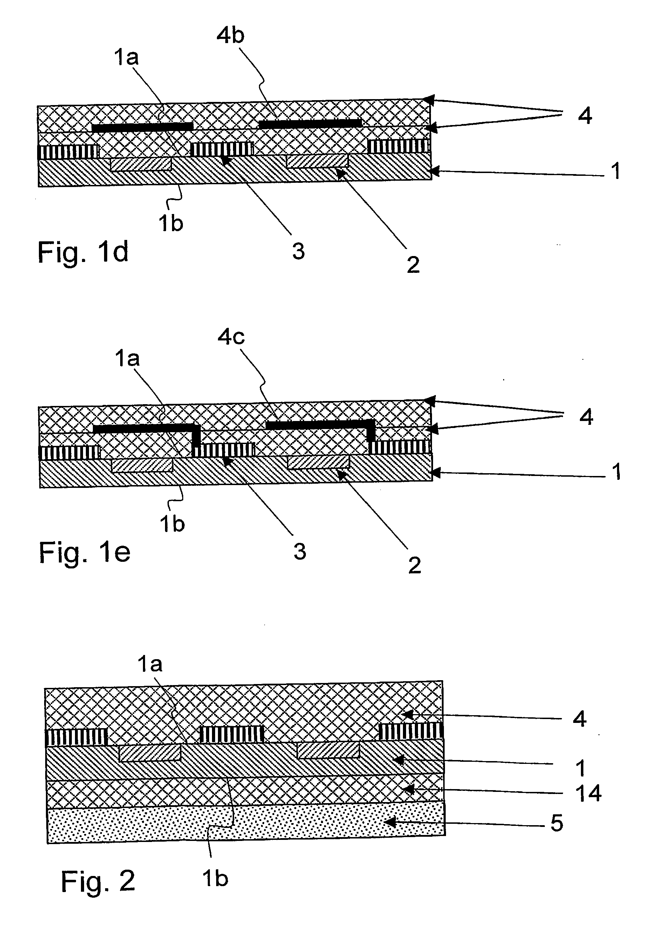

Fig. 1d zeigt das Substrat 1 wie in Fig. 1a, allerdings mit einer zusätzlichen, lediglich abschnittsweise geschlossenen bzw. nicht geschlossenen Schutzschicht 4b, umfassend oder bestehend aus Metall, Keramik, Glas oder Kunststoff. Die Schutzschicht 4b deckt wichtige Bereiche des Substrates, genauer die Bereiche 2 mit Halbleiterstrukturen ab. Die Bereiche 3 mit Anschlussstrukturen sind nicht abgedeckt. Auf der Oberseite der Schutzschicht 4b ist eine weitere abschließende Glasschicht 4 aufgedampft.

Fig. 1e zeigt das Substrat 1 wie in Fig. 1a, allerdings mit einer zusätzlichen nicht geschlossenen Schutzschicht 4c, umfassend oder bestehend aus Metall oder Keramik. Die Schutzschicht 4c enthält zusätzlich Leiterbahnen und/oder passive Bauelemente wie Widerstände, Kondensatoren, Varistoren, Spulen oder ähnliches. Auf der Oberseite der Schutzschicht 4b ist eine weitere abschließende Glasschicht 4 aufgedampft.

Fig. 2 zeigt eine mehrschichtige Deckschicht des Substrats 1, die in diesem Ausführungsbeispiel aus einer Glasschicht 14 und einer Kunststoffschicht 5 auf der Unterseite 1b besteht. Die Glasschicht 14 hat eine Dicke im Bereich von 0,01 bis 50 µm, was für die Abkapselung bzw. den hermetischen Abschluss genügt, während die Kunststoffschicht 5 dicker ist, um dem Wafer als Werkstück größere Stabilität für nachfolgende Bearbeitungsschritte zu verleihen.

Alternativ oder zusätzlich kann in gleicher Weise auch eine Kunststoffschicht auf die Glasschicht 4 auf der Oberseite aufgebracht werden, so dass dort eine entsprechende mehrschichtige Deckschicht aufgebracht ist.

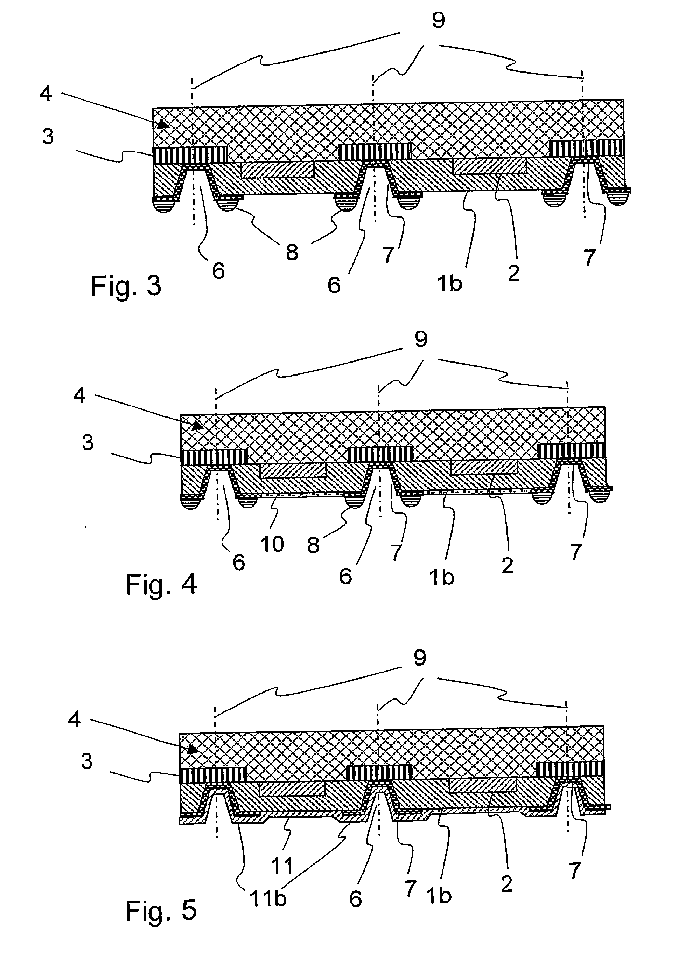

In Fig. 3 ist die weitere Bearbeitung eines Wafers angedeutet. Der Wafer wird an der Unterseite gedünnt und es werden Ätzgruben 6 erzeugt, die bis zu den Anschlussstrukturbereichen 3 reichen, welche als Ätzstop wirken. Die Waferunterseite 1b wird mit einer Kunststofflithographie versehen, wobei die Bereiche mit den Anschlussstrukturen 3 offen bleiben. Es werden nunmehr Leitungskontakte 7 auf der Unterseite erzeugt, was beispielsweise durch Besprühen oder Besputtern geschieht, wodurch leitfähige Schichten 7 im Bereich der Ätzgruben 6 erzeugt werden. Nunmehr wird der bei der Lithographie verwendete Kunststoff von der Waferunterseite 1b entfernt. Alsdann wird ein Ball Grid Array 8 an den leitfähigen Schichten 7 angebracht und der Wafer wird entlang von Ebenen 9 aufgetrennt. Es entstehen eine Mehrzahl von elektronischen Bauteilen, deren Halbleiterstrukturen 2 sicher zwischen der Glasschicht 4 und dem Substrat 1 eingebettet und hermetisch verschlossen ist.

Fig. 4 zeigt eine Abwandlung der Ausführungsform der Fig. 3. Es werden die gleichen Verfahrensschritte wie zuvor ausgeführt, jedoch wird der Kunststoff an der Waferunterseite 1b nicht entfernt und bedeckt die Unterseite als Passivierungs- und Schutzschicht 10.

Fig. 5 zeigt eine Ausführungsform, bei der anstelle der Kunststoffschicht 10 eine aufgedampfte Glasschicht 11 auf der Unterseite 1b des Substrats aufgebracht werden soll. Wie bei der Ausführungsform der Fig. 3 wird der zur Lithographie verwendete Kunststoff an der Waferunterseite 1b entfernt und die gesamte Waferunterseite 1b wird mit dem Glas bedampft, so dass eine 0,01 bis 50µm starke Glasschicht 11 entsteht.

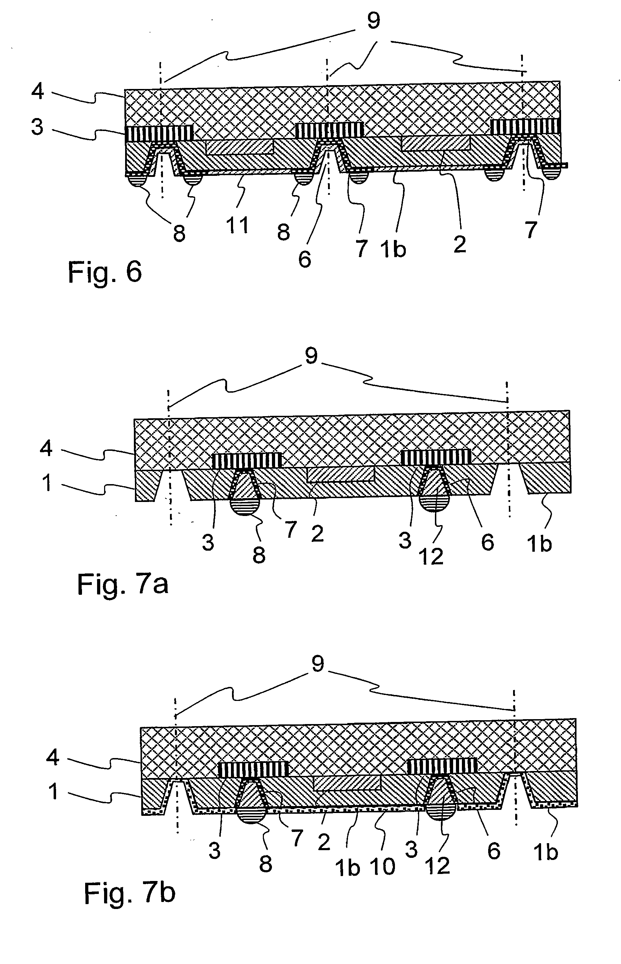

Wie bei 11b dargestellt, bedeckt diese Glasschicht auch die nach außen ragenden Teile der Leitungskontakte 7. Zum Anbringen eines Ball Grid Arrays 8 werden diese Bereiche 11b durch Wegschleifen und / oder Wegätzen freigelegt. Danach werden die Ball Grid Arrays angebracht, wie Fig. 6 zeigt, und es erfolgt eine Auftrennung des Wafers zur Bildung einzelner Bauteile, wie bei 9 angedeutet. Die empfindlichen Halbleiterstrukturen 2 sind nach oben und nach unten jeweils durch eine Glasschicht 4 bzw. 11 mechanisch geschützt.

Bei einer weiteren Ausführungsform der Erfindung wird der Wafer an Trennebenen 9, die nicht durch die Anschlussstrukturbereiche verlaufen, aufgetrennt. Dies hat den Vorteil, dass auch ein seitlicher Passivierungsschutz für die Bauteile gewährleistet werden kann. Fig. 7a zeigt ein Beispiel der Auftrennung, bei welchem nur Material der Deckschicht 4 und des Substrats 1 betroffen ist. Es wird zunächst wie bei den zuvor beschriebenen Ausführungsbeispielen vorgegangen, d.h. der Wafer wird von der Unterseite gedünnt und es werden Ätzgruben 6 erzeugt, die bis zur Unterseite der Anschlussstrukturbereiche 3 reichen. Die Waferunterseite 1b wird lithographiert, wobei die Bond-Pad-Bereiche offen bleiben. Die Leitungskontakte 7 werden im Bereich der Ätzgruben 6 erzeugt, wobei die Ätzgruben außerdem mit leitfähigem Material 12 gefüllt werden. Hier kommt die galvanische Verstärkung durch Ni(P) in Betracht. Nachdem der Kunststoff an der Waferunterseite entfernt worden ist, werden die Ball Grid Arrays 8 angebracht. Danach erfolgt die Auftrennung des Wafers entlang von Ebenen 9. Man erhält elektronische Bauteile mit hermetisch eingeschlossenen Halbleiterstrukturen 2.

Alternativ kann auf das Entfernen der Kunststoffschicht 10 verzichtet werden, so dass diese als Schutzschicht auf der Unterseite 1b bestehen bleibt, wie in Fig. 7b gezeigt ist.

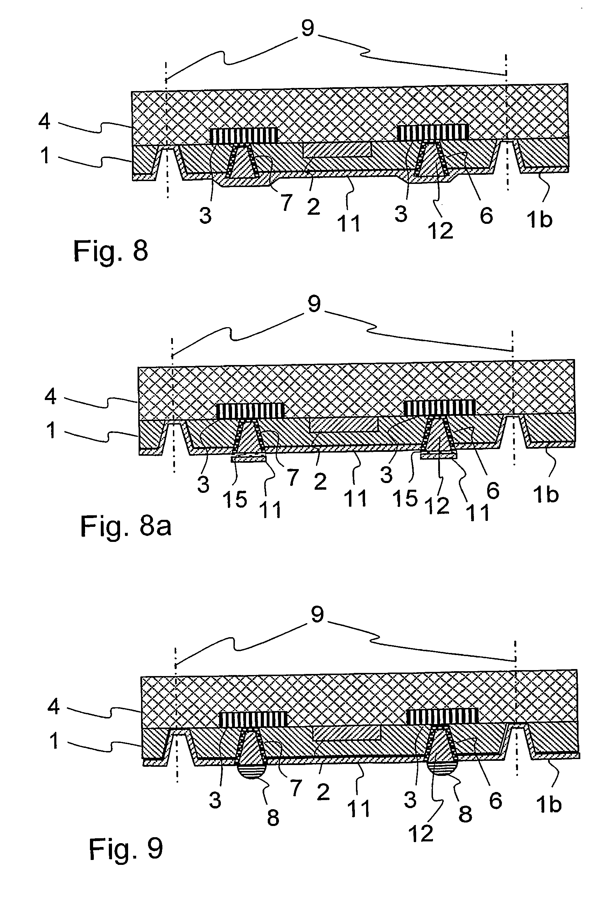

Fig. 8, 8a und 9 zeigen Ausführungsbeispiele mit der Erzeugung einer unterseitigen Glasschicht 11. Es wird analog zur Ausführungsform der Fig. 5 in Verbindung mit Fig. 7 vorgegangen, d.h. es werden gefüllte Anschlussstrukturbereiche erzeugt und die gesamte Unterseite 1b des Wafers wird mit der Glasschicht 11 beschichtet. Anschließend wird die Glasschicht im Bereich der Ätzgruben 6 mittels Schleifen oder Ätzen wie in Fig.8 dargestellt oder durch Ablösen der zuvor durch Lithographie im Bereich der Ätzgruben aufgebrachten Kunststoffschicht 15 mittels Lift Off Technik wie in Fig. 8a dargestellt, entfernt, um darauf die Ball Grid Arrays anzubringen, wie in Fig. 9 dargestellt. Nach Auftrennung entlang der Ebenen 9 werden Bauteile mit gekapselten Halbleiterstrukturen 2 erzielt.

Als besonders geeignet hat sich das Aufdampfglas Typ 8329 der Firma Schott erwiesen, welches folgende Zusammensetzung in Gewichtsprozent aufweist:

| Komponenten | Gew % |
|---|---|
| SiO₂ | 75 - 85 |
| B₂O₃ | 10 - 15 |
| Na₂O | 1 - 5 |
| Li₂O | 0,1 - 1 |
| K₂O | 0,1 - 1 |
| Al₂O₃ | 0,1 - 1 |

Der elektrische Widerstand beträgt ungefähr 10¹⁰ Ω/cm (bei 100°C),
der Brechungsindex etwa 1,470,
die Dielektrizitätskonstante ε etwa 4,7 (bei 25°C, 1MHz)
tan ε etwa 45 x 10⁻⁴ (bei 25°C, 1 MHz).

Zur Erzielung besonderer Eigenschaften der Bauteile kann es zweckmäßig sein, Gläser unterschiedlicher Glaszusammensetzungen für die Glasschichten der Oberseite und der Unterseite zu verwenden. Es ist auch möglich, mehrere Gläser mit unterschiedlichen Eigenschaften, z.B. hinsichtlich Brechungsindex, Dichte, E-Modul, Knoophärte, Dielektrizitätskonstante, tan δ nacheinander auf das Substrat aufzudampfen.

Anstelle der Elektronenstrahlverdampfung können auch andere Mittel zur Überführung von Materialien, die sich als Glas niederschlagen, angewendet werden. Das Verdampfungsmaterial kann sich beispielsweise in einem Tiegel befinden, der durch eine Elektronenstoßheizung aufgeheizt wird. Eine solche Elektronenstoßheizung beruht auf der Emission von Glühelektronen, die auf den Tiegel hin beschleunigt werden, um mit vorbestimmter kinetischer Energie auf das zu verdampfende Material aufzutreffen. Auch mit diesen Verfahren lassen sich Glasschichten erzeugen, ohne das Substrat, auf dem sich das Glas niederschlägt, allzu stark thermisch zu belasten.

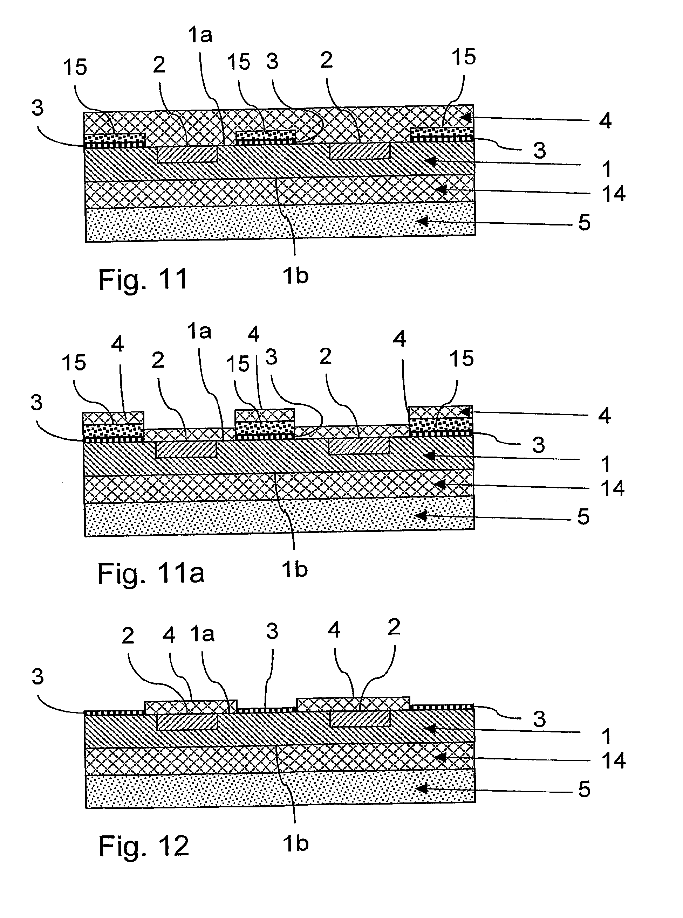

Die Fig. 11, 11a und 12 zeigen eine weitere Ausführungsform der Erfindung. Hierbei sind auf der Unterseite 1b des Substrats 1 eine Glasschicht 14 und eine Kunststoffschicht 5 aufgebracht.

Bezugnehmend auf Fig. 11 werden auf der Oberseite 1a des Substrats 1 mittels Kunststofflithografie die Anschlussstrukturenbereiche Bereiche 3 mit einer strukturierten Kunststoffschicht oder Deckschicht 15 selektiv bedeckt. Die Bereiche mit den Halbleiterstrukturen 2 bleiben frei. Danach wird die Oberseite des Substrats mit einer Glasschicht 4 bedampft. Anschließend wird die Glasschicht zumindest bis zum Niveau der Kunststoffschicht 15 weggeschliffen oder weggeätzt. Nun wird die Kunstoffschicht 15 an der Oberseite 1a selektiv entfernt.

Eine weitere Möglichkeit der Strukturierung zeigt Fig. 11a, in der analog der Fig. 11 mittels Kunststofflithographie die Substratoberseite partiell mit Kunststoff bedeckt wird. In der nun folgenden Glasbedampfung überschreitet die Schichtdicke des aufgedampften Glases nicht die Schichtdicke der Kunststoffschicht. In einem nachfolgenden Prozessschritt kann nun mittels Lift Off Technik die Kunststoffschicht sowie die darauf befindlichen Glasschicht abgelöst werden.

Wie in Fig. 12 gezeigt ist, entsteht durch die Prozessierung analog Fig. 11 oder Fig. 11a ein Wafer, bei welchem die Halbleiterstrukturen 2 mit Glas beschichtet sind, während die Anschlussbereiche 3 freiliegen.

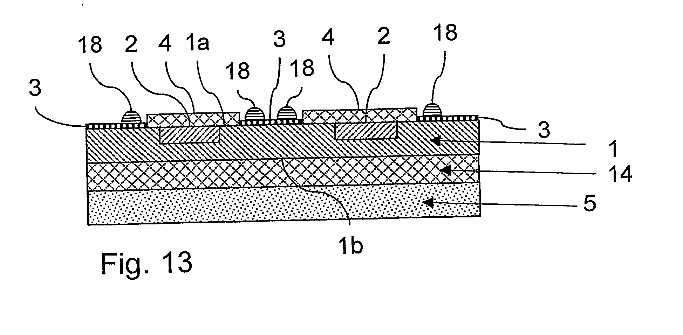

Bezugnehmend auf Fig. 13, welche eine besondere Ausführungsform für die Flip Chip Technik darstellt, werden an der Oberseite des Wafers auf den Anschlussbereichen 3 Ball Grid Arrays 18 aufgebracht.

Schließlich wird der Wafer zu hermetisch dichten Schaltungen zerteilt (sogenanntes dicing) und man erhält kopiergeschützte Chips.

Im Folgenden sind Ergebnisse verschiedener Untersuchungen an einer Schicht aus dem Glas 8329 dargestellt.

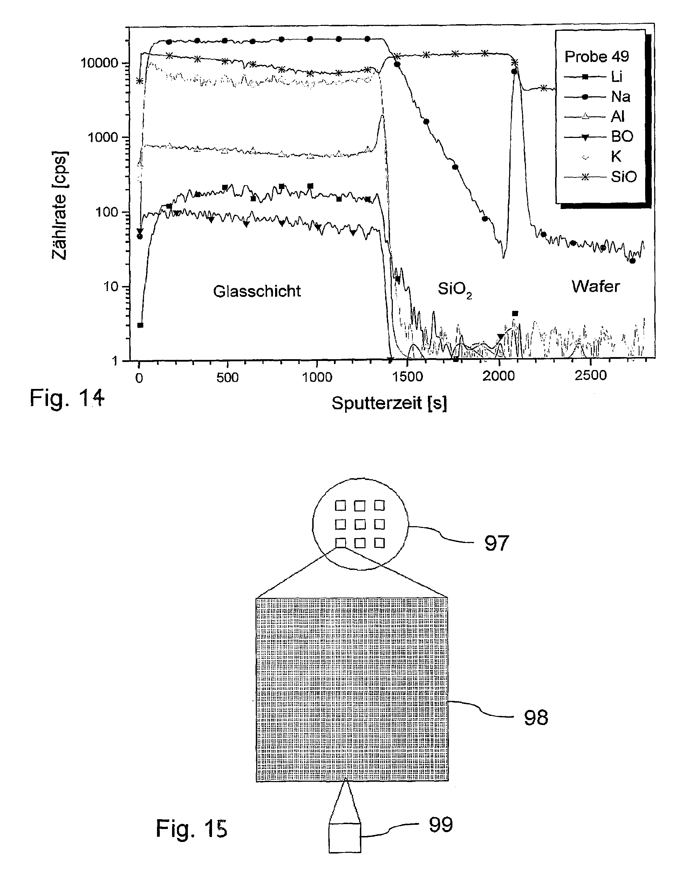

Bezugnehmend auf Fig. 14 sind die Ergebnisse einer TOF-SIMS-Messung gezeigt, wobei die Zählrate als Funktion der Sputterzeit aufgetragen ist. Die Messung charakterisiert den Verlauf der Elementkonzentrationen der Schicht. Es wurde eine Dickenkonstanz für die Schicht von < 1 % der Schichtdicke ermittelt.

Darüber hinaus wurden Dichtigkeitstests der Schicht aus dem Glas 8329 wie folgt durchgeführt.

Es wurde ein Silizium-Wafer mit einer Ätzstopmaske versehen. Wie in Fig. 15 dargestellt ist, wurde der Wafer 97 in neun Lochareale 98 (1 cm x 1 cm) untergliedert. Der Einzellochabstand in den Arealen wurde von Reihe zu Reihe wie folgt verändert.
1. Reihe: 1mm Lochabstand
2. Reihe: 0,5mm Lochabstand
3. Reihe: 0,2mm Lochabstand

Alle quadratischen Löcher 99 besitzen eine Kantenlänge von 15 µm.

Nach Beschichten der nicht strukturierten Waferrückseite mit einer 8µm (Probe A) bzw. 18µm (Probe B) Schicht aus dem Glas 8329, wurde anschließend der Wafer in den Lochflächen bis zum Glas trockengeätzt. Der Erfolg des Ätzens konnte gut im Durchlichtmikroskop beobachtet werden.

Ein Helium Lecktest ergab bei allen 18 gemessenen Arealen eine Leckrate von kleiner als 10⁻⁸ mbar 1/sec.

Erstaunlich ist auch die hohe Festigkeit der Glasschichtbereiche trotz erheblicher Durchwölbung des Wafers während der Messung im jeweiligen Messareal. Auch nach einer Temperung bei 200°C stellte sich keine Veränderung der Glasstruktur ein.

Ferner wurden Beständigkeitamessungen der Kopierschutzschicht nach DIN/ISO durchgeführt. Die Ergebnisse sind in Tabelle 1 wiedergegeben.

**Tabelle 1:**

| | | | |
|---|---|---|---|
| Probenbezeichnung: | **8329** | | |
| **Wasser DIN ISO 719** | Verbrauch HCl [ml/g] | Äquivalent Na₂O [µg/g] | Bemerkungen |
| Klasse | | | |
| **HGB1** | **0,011** | **3** | **keine** |
| **Säure DIN 12116** | Abtrag [mg/dm²] | Gesamt-Oberfläche [cm²] | Bemerkungen/ sichtbare Veränderungen |
| Klasse | | | |
| **1 W** | **0,4** | **2 x 40** | **unverändert** |
| Als **Werkstoff** | | | |
| **Lauge DIN ISO 695** | Abtrag [mg/dm²] | Gesamt-Oberfläche [cm²] | Bemerkungen/ sichtbare Veränderungen |
| Klasse | | | |
| **A2** | **122** | **2x14** | **unverändert** |
| **Als Werkstoff** | | | |

## Patentansprüche

1. Verwendung eines Verfahrens , welches die Schritte umfasst:
Bereitstellen eines Substrats (1), welches Halbleiterstrukturen (2) auf zumindest einer ersten Seite (1a) des Substrats (1) aufweist,
Bereitstellen eines Materials zur Beschichtung des Substrats (1),
Beschichten des Substrats (1) mit einer Beschichtung (4), die aufgedampft wird,
wobei
die Beschichtung (4) ein Borosilikatglas mit Anteilen von Aluminiumoxid und Alkalioxid umfasst und zumindest die Bereiche des Substrats (1), in welchen sich die Halbleiterstrukturen (2) befinden, vollständig von der Beschichtung (4) bedeckt werden
als Schutz gegen das Freilegen der Schaltung eines elektronischen Bauteils durch Wegätzen der Beschichtung (4).

2. Verwendung nach Anspruch 1,
**dadurch gekennzeichnet, dass**
das Substrat (1) eine Halbleiterschicht aus Silizium umfasst.

3. Verwendung nach einem der vorstehenden Ansprüche,
**dadurch gekennzeichnet, dass**
eine geschlossene Schicht als Beschichtung (4) aufgebracht wird.

4. Verwendung nach einem der vorstehenden Ansprüche,
**dadurch gekennzeichnet, dass** eine weitere Schicht eine Abschirmung gegen elektromagnetische Wellen umfasst.

5. Verwendung nach einem der vorstehenden Ansprüche,
**dadurch gekennzeichnet, dass**
die Beschichtung (4) durch thermische Bedampfung oder durch Elektronenstrahlbedampfung aufdampft wird.

6. Verwendung nach einem der vorstehenden Ansprüche,
**dadurch gekennzeichnet, dass**
die Beschichtung (4) mit einer Dicke von 0,01 bis 1000 µm auf das Substrat (1) aufgebracht wird.

7. Verwendung nach einem der vorstehenden Ansprüche,
**dadurch gekennzeichnet, dass**
das Beschichten des Substrats (1) mit der Beschichtung (4) bei einer Bias-Temperatur von unter 300° C durchgeführt wird.

8. Verwendung nach einem der vorstehenden Ansprüche,
**dadurch gekennzeichnet, dass**
das Beschichten des Substrats (1) mit der Beschichtung (4) bei einem Druck von 10⁻³ mbar bis 10⁻⁷ mbar durchgeführt wird.

9. Verwendung nach einem der vorstehenden Ansprüche,
**dadurch gekennzeichnet, dass**
eine weitere Glasschicht (14) auf eine der ersten Seite (1a) gegenüberliegende zweite Seite (1b) des Substrats (1) aufgebracht wird.

10. Verwendung nach einem der vorstehenden Ansprüche,
**dadurch gekennzeichnet, dass**
eine Kunststoffschicht (5) auf eine der ersten Seite (1a) gegenüberliegende zweite Seite (1b) des Substrats (1) aufgebracht wird.

11. Verwendung nach einem der vorstehenden Ansprüche,
**dadurch gekennzeichnet, dass**
die Halbleiterstrukturen (2) elektronische Entschlüsselungsmittel umfassen.

12. Verwendung einer Beschichtung (4) umfassend ein Borosilikatglas mit Anteilen von Aluminiumoxid und Alkalioxid als Schutz gegen das Freilegen der Schaltung eines elektronischen Bauteils durch Wegätzen der Beschichtung, wobei das elektronische Bauteil
eine elektronische Schaltung auf einem Substrat (1) mit Halbleiterstrukturen (2) auf einer ersten Seite (1a) des Substrats (1) umfasst, wobei
die Beschichtung (4) zumindest die Bereiche des Substrats (1), in welchen sich die Halbleiterstrukturen (2) befinden, vollständig bedeckt.

13. Verwendung nach Ansprüch 12, **dadurch gekennzeichnet, dass**
das Substrat (1) eine Halbleiterschicht aus Silizium umfasst.

14. Verwendung nach einem der Ansprüche 12 oder 13, **dadurch gekennzeichnet, dass**
die Beschichtung (4) eine geschlossene Schicht umfasst.

15. Verwendung nach einem der Ansprüche 12 bis 14, **dadurch gekennzeichnet, dass**
eine weitere Schicht eine Abschirmung gegen elektromagnetische Wellen umfasst.

16. Verwendung nach einem der Ansprüche 12 bis 15, **dadurch gekennzeichnet, dass**
die Beschichtung eine Dicke von 0,01 µm bis 1000 µm aufweist.

17. Verwendung nach einem der Ansprüche 12 bis 16, **dadurch gekennzeichnet, dass**
die elektronische Schaltung Entschlüsselungsmittel umfasst.

## Claims

1. Use of a method which comprises the steps of:
providing a substrate (1) having semiconductor structures (2) on at least a first surface (1a) of the substrate (1);
providing a material for coating the substrate (1);
coating the substrate (1) with a coating (4) which is vapor deposited; wherein
the coating (4) comprises a borosilicate glass including proportions of aluminum oxide and alkali oxide, and wherein at least those areas of the substrate (1) in which the semiconductor structures (2) are provided are completely covered by the coating (4);
for protecting the circuit of an electronic component from being exposed by etching away the coating (4).

2. Use according to claim 1, **characterized in that** the substrate (1) comprises a silicon semiconductor layer.

3. Use according to any of the preceding claims, **characterized in that** a closed layer is applied as a coating (4).

4. Use according to any of the preceding claims, **characterized in that** a further layer comprises a shield against electromagnetic waves.

5. Use according to any of the preceding claims, **characterized in that** the coating (4) is vapor deposited by thermal vapor deposition or by electron beam vapor deposition.

6. Use according to any of the preceding claims, **characterized in that** the coating (4) is applied onto the substrate (1) with a thickness from 0.01 to 1000 µm.

7. Use according to any of the preceding claims, **characterized in that** the substrate (1) is coated with the coating (4) at a bias temperature below 300 °C.

8. Use according to any of the preceding claims, **characterized in that** the substrate (1) is coated with the coating (4) at a pressure from 10⁻³ mbar to 10⁻⁷ mbar.

9. Use according to any of the preceding claims, **characterized in that** a further glass layer (14) is applied onto a second surface (1b) of the substrate (1) opposite the first surface (1a).

10. Use according to any of the preceding claims, **characterized in that** a plastic layer (5) is applied onto a second surface (1b) of the substrate (1) opposite the first surface (1a).

11. Use according to any of the preceding claims, **characterized in that** the semiconductor structures (2) comprise electronic decryption means.

12. Use of a coating (4) that comprises a borosilicate glass having proportions of aluminum oxide and alkali oxide as a protection against exposure of the circuit of an electronic component by etching away the coating;
wherein the electronic component comprises an electronic circuit on a substrate (1) including semiconductor structures (2) on a first surface (1a) of the substrate (1);
wherein the coating (4) completely covers at least those areas of the substrate (1) on which the semiconductor structures (2) are provided.

13. Use according to claim 12, **characterized in that** the substrate (1) comprises a silicon semiconductor layer.

14. Use according to any of claims 12 or 13, **characterized in that** the coating (4) comprises a closed layer.

15. Use according to any of claims 12 to 14, **characterized in that** a further layer comprises a shield against electromagnetic waves.

16. Use according to any of claims 12 to 15, **characterized in that** the coating has a thickness from 0.01 µm to 1000 µm.

17. Use according to any of claims 12 to 16, **characterized in that** the electronic circuit comprises decryption means.

## Revendications

1. Utilisation d'un procédé qui comprend les étapes de :
mise à disposition d'un substrat (1) qui présente des structures de semi-conducteurs (2) sur au moins une première face (1a) du substrat (1),
mise à disposition d'une matière pour le revêtement du substrat (1),
enduction du substrat (1) avec un revêtement (4) qui est vaporisé,
dans laquelle
le revêtement (4) comprend un verre borosilicaté avec des fractions d'oxyde d'aluminium et d'oxyde alcalin et au moins les régions du substrat (1) où se trouvent les structures de semi-conducteurs (2) sont entièrement recouvertes par le revêtement (4),
à titre de protection contre la mise à nu du circuit d'un composant électronique par attaque du revêtement (4).

2. Utilisation selon la revendication 1, **caractérisée en ce que** le substrat (1) comprend une couche de semi-conducteur en silicium.

3. Utilisation selon l'une des revendications précédentes, **caractérisée en ce qu'**une couche fermée est déposée comme revêtement (4).

4. Utilisation selon l'une des revendications précédentes, **caractérisée en ce qu'**une autre couche comprend un écran vis-à-vis des ondes électromagnétiques.

5. Utilisation selon l'une des revendications précédentes, **caractérisée en ce que** le revêtement (4) est vaporisé par évaporation thermique ou par évaporation par faisceau d'électrons.

6. Utilisation selon l'une des revendications précédentes, **caractérisée en ce que** le revêtement (4) est déposé à une épaisseur de 0,01 à 1000 µm sur le substrat (1).

7. Utilisation selon l'une des revendications précédentes, **caractérisée en ce que** l'enduction du substrat (1) est réalisée avec le revêtement (4) à une température de polarisation inférieure à 300°C.

8. Utilisation selon l'une des revendications précédentes, **caractérisée en ce que** l'enduction du substrat (1) est effectuée avec le revêtement (4) à une pression de 10⁻³ mbar à 10⁻⁷ mbar.

9. Utilisation selon l'une des revendications précédentes, **caractérisée en ce qu'**une autre couche de verre (14) est déposée sur une seconde face (1b) du substrat (1) opposée à la première face (1a).

10. Utilisation selon l'une des revendications précédentes, **caractérisée en ce qu'**une couche de plastique (5) est déposée sur une seconde face (1b) du substrat (1) opposée à la première face (1a).

11. Utilisation selon l'une des revendications précédentes, **caractérisée en ce que** les structures de semi-conducteurs (2) comprennent des moyens de décryptage électroniques.

12. Utilisation d'un revêtement (4) comprenant un verre borosilicaté avec des fractions d'oxyde d'aluminium et d'oxyde alcalin à titre de protection contre la mise à nu du circuit d'un composant électronique par attaque du revêtement, dans laquelle le composant électronique comprend un circuit électronique sur un substrat (1) avec des structures de semi-conducteurs (2) sur une première face (1a) du substrat (1), dans laquelle
le revêtement (4) recouvre entièrement au moins les régions du substrat (1) où se trouvent les structures de semi-conducteurs (2).

13. Utilisation selon la revendication 12, **caractérisée en ce que** le substrat (1) comprend une couche de semi-conducteur en silicium.

14. Utilisation selon l'une des revendications 12 ou 13, **caractérisée en ce que** le revêtement (4) comprend une couche fermée.

15. Utilisation selon l'une des revendications 12 à 14, **caractérisée en ce qu'**une autre couche comprend un écran vis-à-vis des ondes électromagnétiques.

16. Utilisation selon l'une des revendications 12 à 15, **caractérisée en ce que** le revêtement présente une épaisseur de 0,01 µm à 1000 µm.

17. Utilisation selon l'une des revendications 12 à 16, **caractérisée en ce que** le circuit électronique comprend des moyens de décryptage.
